# EUROPEAN PATENT APPLICATION

(11) **EP 2 037 504 A1**
(43) Veröffentlichungstag der Anmeldung: **18.03.2009**
(21) Anmeldenummer: 07794035.1
(22) Anmeldetag: 05.06.2007
(51) Int. Cl.: H01L 31/04

(54) **FOTOUMSETZER**

(30) Priorität: 08.06.2006 RU 2006120073
(71) Anmelder: Tsoi, Bronya, Moscow, 117342 (RU)
(72) Erfinder: IDRISOV, Idris Magomedovich, Makhachkala, 367033 (RU); TSOI, Valeryan Eduardovich, Moskovskaya obl, 142000 (RU); BUDISHEVSKY, Jury Dmitrievich, Bryansk, 241005 (RU); TSOI, Tatyana Sergeevna, Moscow, 117418 (RU)
(74) Vertreter: Lemcke, Brommer & Partner
(86) Internationale Anmeldenummer: PCT/RU2007/000301
(87) Internationale Veröffentlichungsnummer: WO 2007/145546

(57) **Zusammenfassung**

Die Erfindung betrifft Wandler zur Umwandlung der Energie von elektromagnetischen Wellen und ist für die Erzeugung der elektrischen Enegrgie geeignet. Der Wandler enthält N > 1 Gebiete mit gleichnamiger Leitfähigkeit, wobei N für eine ganze Zahl steht, und ein Gebiet mit entgegengesetzter Leitfähigkeit unter Bildung von N einzelnen gleichartigen pn-Übergängen, wobei eine erste Elektrode an jedes der erwähnten Gebiete mit gleichnamiger Leitfähigkeit und eine zweite Elektrode an das Gebiet mit entgegengesetzter Leitfähigkeit angrenzt. Diese erste Elektrode kann jedes der Gebiete mit gleichnamiger Leitfähigkeit über dessen Umfang umgreifen und zumindest teilweise oder vollständig jedes dieser Gebiete abdecken. Ein in dieser Weise gebauter Wandler ist in der Lage, nicht nur einen üblichen Frequenzbereich der elektromagnetischen Wellen (einen optischen Bereich), sondern auch einen breiteren Arbeitsfrequensbereich der elektromagnetischen Wellen unter Sicherung des Betriebes des Wandlers zu jeder Tages- und Nachtstunde umzuwandeln. Der erfindungsgemässe Wandler zeichnet sich auch durch eine höhere Leistung und einen höheren Wirkungsgrad bei gleichzeitiger Sicherung einer hohen Genauigkeit und Stabilität der Ausgangskennlinien aus und vermag unter Bedingungen beachtlicher Temperaturgefälle betrieben zu werden.

## Beschreibung

### Gebiet der Technik

Die Erfindung bezieht sich auf Wandler zur Umwandlung der Energie von elektromagnetischen Wellen.

### Hintergrund der Erfindung

Heute bestehende, am weitesten verbreitete Industriewandler zur Umwandlung elektromagnetischer Wellen beruhen auf sogenannten fotovoltaischen (bzw. fotoelektrischen) Effekten, also auf einer Trennung von Ladungen und der Bildung von Elektronen-Löcher-Paaren in Halbleiterwerkstoffen infolge der Absorption einer elektromagnetischen Strahlung. Die modernen Wandler sind in der Lage, einen verhältnismässig geringen Anteil der Energie einer elektromagnetischen Strahlung im Bereich eines sichtbaren Lichtes (10¹⁴ bis 10¹⁵ Hz, incl. eines geringen Anteiles der Frequenzen aus dem IR-Bereich) zu empfangen und umzuwandeln, welches Licht die Erdoberfläche lediglich zu Tagesstunden bei zufriedenstellenden Witterungsverhältnissen ungehindert erreicht.

Die derzeit existierenden fotovoltaischen (oder fotoelektrischen) Wandler gestatten es nicht, einen niedrigeren Wellenbereich zu empfangen und umzuwandeln, was eben deren wesentlicher Nachteil ist. Unterdes erreicht der unterhalb des sichtbaren Anteiles des Sonnenlichtspektrums liegende Bereich der elektromagnetischen Wellen, insbesondere ein Millimeterwellenbereich (jedoch von mehr als 3 GHz) ebenfalls ungestört die Erdoberfläche, wobei im Unterschied zum sichtbaren Bereich dies zu jeder Tages- und Nachtstunde geschieht. Die Inanspruchnahme des Frequenzbereiches der rund um die Uhr erreichbaren elektromagnetischen Wellen könnte als eine zusätzliche und wesentliche Unterstützung bei der Gewinnung der elektrischen Energie aus alternativen Energiequellen dienen.

Zur Zeit bekannte elektrische Wandler werden bei Anwendung der herkömmlichen Halbleitertechnik gebaut, welcher zufolge in einem Basen-Halbleiterwerkstoff (mit einer p- oder n-Leitung) durch eine Dotierung (Diffusion) von Beimengungen pn-Übergänge erzeugt werden (Alfjorow Sh.I., Andrejew W.M., Rumjanzew W.D. Tendenzii i perspektiwy raswitija solnetschnoj energetiki (Entwicklungstrends und -aussichten der Solarenergetik). Fisika i technika poluprowodnikow (Halbleiterphysik und -technik), 2004, Bd. 38, Ausg. 8, Seiten 937 bis 948; Meitin M. Fotovoltaika, materialy, technologii, perspektivy (Fotovoltaik : Werkstoffe, Technologien und Aussichten). Elektronika : nauka, technologia, business (Elektronik : Wissenschaft, Technologie, Business. 2000, Nr. 6, Seiten 40 bis 46; Stepanenko I.P. Osnowy mikroelektroniki (Grundlagen der Elektronik), 2. Aufl., Moskau; Laboratoria basowych znanij (Labor für die Grundkenntnisse), 2004, S. 488). Bei allen Konstruktionen der Elementarzelle von Wandlern, welche eine übliche Halbleiterdiode sind (und welche im Modus eines fotovoltaischen Elementes betrieben werden), wird generell ein einziger pn-Übergang, also ein Akzeptor- oder ein Donatorgebiet, geschaffen. An den pn-Übergang grenzen über das **p**-Gebiet zwei gesonderte Einzelelektroden, also eine Anode (eine positive Elektrode) und eine Kathode (eine negative Elektrode) an.

Um zu sichern, dass eine solche Diode im Modus eines fotovoltaischen Elementes betreibbar ist, wird dem pn-Übergang ein Fluß der elektromagnetischen Wellen (ein Lichtstrom) zugeführt, so dass sich Elektronen-Löcher-Paare aufbauen und unter Beeinflussung des Innenfeldes des pn-Überganges eine Trennung der Ladungen stattfindet.

Bei der Gestaltung der pn-Übergänge sorgt man um eine viel höhere Konzentration von Dotierungsbeimengungen, als die Konzentration der Beimengung in der Basisschicht des Werkstoffes (mit einer p- oder n-Leitung), um dort verfügbare hauptsächliche freie Ladungsträger zu neutralisieren und eine Leitfähigkeit mit entgegengesetztem Vorzeichen schaffen zu können. An der Grenze der n- und p-Schichten bilden sich infolge eines Abflusses der Ladungen verarmte Zonen mit einer unausgeglichenen positiven Raumladung in der n-Schicht und einer negativen Raumladung in der p-Schicht aus. Diese Zonen bilden gemeinschaftlich eben einen pn-Übergang. Eine am pn-Übergang entstandene Potentialschwelle (eine Kontaktpotentialdifferenz) hindert am Durchgang der Majotitätsladungsträger, also der Elektronen auf der Seite der p-Schicht, dafür lässt sie aber ungehindert die Minoritätsladungsträger in entgegengesetzten Richtungen durch. Dieser Eigenschaft der pn-Übergänge ist eben die Erzeugung einer Foto-EMK bei einer Beeinflussung des Wandlers durch eine elektromagnetische Strahlung zu verdanken.

Die bei der elektromagnetischen Bestrahlung erzeugten unausgeglichenen Ladungsträger (Elektronen-Löcher-Paare) trennen sich unter Einfluss des elektrischen Feldes des pn-Überganges, so dass die Minoritätsladungsträger (also die Elektronen) den Übergang frei durchlaufen, während die Majoritätsladungsträger (die Löcher) aufgehalten werden. Somit durchfliesst bei der Strahlung den pn-Übergang in beiden Richtungen ein Strom der unausgeglichenen Minoritätsladungsträger, also solcher der Elektronen und Löcher. Wenn nun der äussere Stromkreis kurzgeschlossen wird, kommen dann die Elektronen aus der n-Schicht nach Beendigung der Belastungsfunktion in die p-Schicht zurück und vereinigen sich dort mit im Innern des Wandlers in entgegengesetzter Richtung wandernden Löchern. Um die Elektronen zu sammeln und dem äusseren Stromkreis zuzuführen, ist an der Oberfläche einer Halbleiterstruktur des Wandlers ein Kontaktsystem, also Elektroden, vorgesehen.

Der Vorgang der Entstehung und Trennung der unausgeglichenen Minoritätsladungsträger, also der Elektronen-Löcher-Paare, in Wandlern steht mit solchem der Rekombination dieser Paare an der Oberfläche und im Innern eines Wandlers in Wettbewerb. Das Ergebnis des Wettbewerbs dieser beiden Vorgänge, also der Entstehung der Elektronen-Löcher-Paare und deren Rekombination, beeinflusst den Wert des Fotostromes. Es ist offensichtlich, dass der Rekombinationsvorgang eine Herabsetzung des Fotostromes und letztendlich eine Senkung des Wirkungsgrades von Wandlern zur Folge hat. Die grundsätzlichen irreversiblen Energieverluste in Wandlern, durch welche deren Wirkungsgrad gemindert wird, sind verursacht durch : 1) die Reflexion der Sonnenstrahlung durch die Wandleroberfläche und den Durchlauf eines Teiles der Strahlung durch den Wandler ohne deren Absorption durch den letzteren ; 2) die Zerstreuung der überschüssigen Fotonenergie bei Wärmeschwingungen des Gitters ; 3) die Rekombination der entstandenen Fotopaare an der Oberfläche des Wandlers und in dessen Innerem ; 4) den Innenwiderstand des Wandlers sowie einige andere physikalische Vorgänge.

Für die Bildung von Elektronen-Löcher-Paaren und die Entstehung von fotovoltaischen Effekten soll die folgende Voraussetzung erfüllt werden : die Energiegrösse der Einfallswelle am pn-Übergang E = hv (wobei h für die Planck-Konstante und v für die Wellenfrequenz stehen) soll gleich oder mehr als die Energie der Breite der verbotenen Zone ΔE des Halbleiters : hv ≥ ΔE sein.

Bei verschiedenen Halbleiterwerkstoffen beträgt die Breite der verbotenen Zone wie folgt : Galliumarsenid (GaAs) : ΔE = 1,43 eV; Kupfer- und Indiumdiselenid (Cu-, InSeOB_{2B} ): ΔE = 1 eV ; Kadmiumtellurid (CdTe) : ΔE = 1,44 eV ; Silizium : ΔE = 1,1 eV ; Germanium : ΔE = 0,72 eV.

Die Breite der verbotenen Zone kan sich je nach den in den Halbleiterwerkstoff eingebrachten Beimengungen verändern. Die Halbleiter mit einer Breite der verbotenen Zone von 1,4 eV sind in der Lage, die elektromagnetischen Wellen, angefangen von Funkwellen aus dem UKW-Bereich (∼ 4. 10⁷ Hz) und darüber, zu verschlucken. In der Tat beträgt die Energie einer elektromagnetischen Welle mit einer Frequenz von 4.10⁷ Hz (einer elektromagnetischen Welle aus dem UKW-Bereich mit einer Frequenz von 4.10⁷ Hz) : hv = 6,626 . 10⁻²⁷ J . s . 4 . 10⁷ Hz = 2,65 . 10⁻¹⁹ J = 1,65 eV. Derzeit wird ein beachtlicher Teil des Spektrums von elektromagnetischen Wellen (die unterhalb der Lichtfrequenzen gelegen sind), abgesehen von der potentiellen Möglichkeit und dem Interesse an deren Umwandlung in die elektrische Energie, vorläufig nicht in Anspruch genommen.

In der Fachliteratur sind zahlreiche Ausführungsformen, Konstruktionen und Verfahren zur Herstellung von Wandlern für elektromagnetische Wellen beschrieben, welche Wandler auf fotovoltaischen Effekten in Halbleiterwerkstoffen beruhen (Alfjorow Sh.I., Andrejew W.M., Rumjanzew W.D. Tendenzii i perspektiwz paswitija solnetschnoj energetiki (Entwicklungstrends und -aussichten der Solarenergetik). Fisika i technika poluprowodnikow (Halbleiterphysik und - technik), 2004, Bd. 38, Ausg. 8, S. 937 bis 948; Meitin M. Fotovoltaika, materialy, technologii, perspektivy (Fotovoltaik : Werkstoffe, Technologien und Aussichten). Elektronika : nauka, technologia, business (Elektronik : Wissenschaft, Technologie, Business). 2000, Nr. 6, S. 40 bis 46; Stepanenko I.P. Osnowy mikroelektroniki (Grundlagen der Elektronik), 2. Aufl., Moskau; Laboratoria basowych snanij (Labor für die Grundkenntnisse), 2004, S. 488).

Gegenwärtig wirken als ernsthafter Nachteil der bekannten fotoelektrischen Halbleiterwandler eine hohe Grösse und eine Streuung des inneren Scheinwiderstandes RB_{p B} in pn-Übergängen, der sich aus einem Wirkanteil (R), einem kapazitiven Anteil (C) und einem induktiven Anteil (L) zusammensetzt. Dies erbringt eine Instabilität der elektrischen Werte und eine Verschlechterung der Voltampercharakteristiken sowie eine Senkung der Leistung und jeweils des Wirkungsgrades der Wandler. So weisen z. B. die modernen industriellen fotoelektrischen Wandler einen niedrigen Wirkungsgrad auf, welcher sich bei einem Wandler beispielsweise auf Grundlage eines amorphen Siliziums auf 6 bis 12 %, eines monokristallinen Siliziums auf 12 bis 15 % und eines Galliumarsenides auf 20 bis 24 % beläuft. Ein weiterer ernsthafter Nachteil der modernen Wandler, ausser den eingangs erwähnten Nachteilen, ist die Rekombination von Elektronen-Löcher-Paaren.

Nachteilig wirkt sich bei den bestehenden modernen fotoelektrischen Wandlern auch deren hoher Aufwand aus. Heute beträgt auf dem Weltmarkt der Preis eines Wattes der "alternativen", durch die elektromagnetische Strahlung erzeugten Energie US$ ca. 5. Gegenwärtig können sich lediglich einige Länder, in denen eine staatliche Dotation besteht, eine umfangreiche Entwicklung der alternativen solaren Energetik leisten. Dazu zählen solche Länder wie Deutschland, Japan und die USA. Es wird angenommen, dass bei einem Preis eines Wattes der erzeugten solaren Elektroenergie von US$ 2 in der alternativen Energetik ein weltbezogener Durchbruch eintreten wird.

### Darlegung der Erfindung

Es ist daher notwendig, eine prinzipiell neue Generation von modernen Wandlern zu schaffen, welche in der Lage sind, nicht nur den üblichen Frequenzbereich der Lichtwellen, sondern auch einen breiteren Arbeitsfrequenzbereich der elektromagnetischen Wellen zur Sicherung eines Betriebes von Wandlern zu jeder Tages- und Nachtstunde umzuwandeln. Solche Wandler sollen von den vorerwähnten Nachteilen frei sein und durch eine bessere Leistung und einen höheren Wirkungsgrad sowohl bei einer gleichzeitigen Erweiterung des Bereiches der umzuwandelnden Arbeitsfrequenzen von elektromagnetischen Wellen (von niedrigen über übermässige bis hin zu noch höheren Frequenzen), als auch bei einer hohen Genauigkeit und Stabilität der Ausgangskennlinien, die auch bei beträchtlichen Temperaturgefällen anwendbar sind, gekennzeichnet sein. Darüber hinaus sollen diese Wandler billig und wirtschaftlich sowie verfahrenstechnisch an den modernen Produktionsprozeß anpassbar sein.

Die gennante Aufgabe wird dadurch gelöst, dass ein Wandler mit zumindest einem p-Gebiet und zumindest einem n-Gebiet sowie mit einer ersten und einer zweiten Elektrode erfindungsgemäss N > 1 Gebiete mit gleichnamiger Leitfähigkeit, wobei N eine ganze Zahl ist, und ein Gebiet mit einer entgegengesetzter Leitfähigkeit unter Bildung von N einzelner gleichartiger pn-Übergänge aufweist, wobei die erste Elektrode an jedes der genannten Gebiete N mit gleichnamiger Leitfähigleit und die zweite Elektrode an das besagte Gebiet mit entgegengesetzter Leitfähigkeit angrenzt.

Bei einer ersten besonderen Ausführungsform umgreift die erste Elektrode jedes der Gebiete mit gleichnamiger Leitfähigkeit über dessen Umfang.

Bei einer anderen besonderen Ausführungsform bedeckt die genannte erste Elektrode mindestens z. T. jedes der erwähnten Gebiete.

Hierbei bedeckt die erste Elektrode vorteilhafterweise vollständig jedes der angegebenen Gebiete mit gleichnamiger Leitfähigkeit (über dessen gesamten Umfang).

Als Weiterbildung der letzteren besonderen Ausführungsform weisen die an jedes der Gebiete mit gleichnamiger Leitfähigkeit angrenzenden Abschnitte (Elemente) der ersten Elektrode eine polygonale Form, insbesondere eine rechteckige, quadratische, hexagonale (bei unterschiedlichem Verhältnis der Seitengrössen), achteckige (bei unterschiedlichem Verhältnis der Seitengrössen) oder zwölfeckige (bei unterschiedlichem Verhältnis der Seitengrössen) oder eine runde oder eine elliptische oder eine andere bekannte Konfiguration, auf.

Als Weiterbildung jeder der vorangehenden besonderen Ausführungsformen der Erfindung besteht mindestens einer der an eines der Gebiete mit gleichnamiger Leitfähigkeit angrenzenden Abschnitte in der Abdeckzone aus einer Zahl M > 1 von parallel geschalteten und zu einer Strombaueinheit zusammengefassten gleichartigen Einzelelementen, wobei M eine ganze Zahl ist.

Hierbei kann zumindest eines der genannten gleichartigen Elemente des Abschnittes der ersten Elektrode von einem damit benachbarten ähnlichen Element mittels eines Oxidspaltes (oder eines beliebigen anderen dielektrischen Spaltes) oder einer durchgehenden Öffnung getrennt sein.

Bei einer weiteren vorteilhaften Ausführungsform enthält der Abschnitt einer ersten Elektrode, der aus parallel geschalteten gleichartigen Einzelelementen besteht, K durchgehende Öffnungen, wobei K eine ganze Zahl und mehr als 1 ist.

Darüber hinaus können die genannten Gebiete mit gleichnamiger Leitfähigkeit p-Gebiete sein, während das Gebiet mit entgegengesetzter Leitfähigkeit ein n-Gebiet ist. Es ist auch möglich, dass die genannten Gebiete mit gleichnamiger Leitfähigkeit n-Gebiete sind, indem das Gebiet mit entgegengesetzter Leitfähigkeit ein p-Gebiet ist.

Um die gestellte Aufgabe zu lösen, ist es auch sinnvoll, die Zahl N von Gebieten mit gleichnamiger Leitfähigkeit zu vergrössern, es mag insbesondere bei verschiedenen Ausführungsformen der Erfindung vorteilhaft sein, dass N a) mindestens 2, b) mindestens 4, c) mindestens 8, d) mindestens 16, e) mindestens 100, f) mindestens 1000, g) mindestens 20000 und h) mindestens 20 000000 usw. ist.

Im Rahmen der vorliegenden Erfindung bedient man sich einer folgenden Terminologie.

Bei Halbleiteranordnungen kommen traditionsgemäss zwei grundsätzliche Leitfähigkeitstype, nämlich eine p-Leitung und eine n-Leitung, in Frage. Entsprechend werden bei dieser Erfindung unter Gebieten mit gleichnamiger Leitfähigkeit Gebiete eines Wandlers verstanden, von denen jedes Gebiet durch eine p-Leitung (jeweils ein p-Gebiet) oder als Variante durch eine n-Leitung (jeweils ein n-Gebiet) gekennzeichnet ist. Als Folge hiervon versteht man unter einem Gebiet mit entgegengesetzter Leitfähigkeit ein Gebiet eines Wandlers, dessen Leitfähigkeit sich von derselben der Gebiete mit gleichnamiger Leitfähigkeit unterscheidet, falls jedoch die Gebiete mit gleichnamiger Leitfähigkeit p-Gebiete (oder als Variante n-Gebiete) sind, stellt dann das Gebiet mit entgegengesetzter Leitfähigkeit ein n-Gebiet (jeweils ein p-Gebiet) dar.

Ferner versteht man unter gleichartigen pn-Übergängen solche Übergänge, die durch ein gleiches Verfahren (unter gleichen Verhältnissen) aus ein und denselben Werkstoffen (bei Anwendung der ein und derselben Beimengungen in gleichen Konzentrationen) hergestellt sind und im wesentlichen gleiche geometrische Maße, eine gleiche Konfiguration und Form sowie gleiche struktur-empfindliche physikalische (mechanische, elektrische, elektromagnetische usw.) Werte und Eigenschaften aufweisen. Die Gleichartigkeit der pn-Übergänge ist eine notwendige und ausreichende Bedingung (also ein Äquivalent) für die Gleichartigkeit der Gebiete mit gleichnamiger Leitfähigkeit (der p- oder n-Gebiete). In ähnlicher Weise versteht man unter gleichartigen Elementen der Abschnitte der ersten Elektrode die Elemente dieser Elektrode, die durch ein gleiches Verfahren aus ein und demselben Werkstoff (aus welchem eigentlich die erste Elektrode selbst besteht) hergestellt sind und die im wesentlichen gleiche Maße und eine gleiche Form sowie im wesentlichen gleiche struktur-empfindliche physikalische (mechanische, elektrische, elektromagnetische usw.) Werte und Eigenschaften besitzen. Der Gebrauch des Fachausdruckes "gleichartig" liegt darin begründet, dass infolge von bestehenden Toleranzen für einzelne Parameter eines am Ausgang anfallenden Produktes bei jedem technologischen Prozeß ein Fall, bei dem alle pn-Übergänge absolut identisch ausfallen, in der Praxis schwer erreichbar ist, obwohl er als bevorzugt angesehen wird.

Unter der Einzelanordnung der pn-Übergänge versteht man weiters das Fehlen deren, sich überschneidender oder überdeckender Abschnitte, d. h. dass jeder der pn-Übergänge gesondert (einzeln) von den restlichen pn-Übergängen im Wandler angeordnet ist. Dies ist praktisch einer gesonderten Anordnung (Einzelanordnung) der genannten Gebiete mit gleichnamiger Leitfähigkeit gleichzusetzen. In ähnlicher Weise versteht man unter der Enzelanordnung der vorerwähnten Elemente der ersten Elektrode das Fehlen deren, sich überschneidender oder einander überdeckender Abschnitte, was durch die Anordnung eines Oxidspaltes (insbesondere eines oxidierten Abschnittes der ersten Elektrode) oder einer durchgehenden Öffnung (die Entfernung eines zwischen diesen Elementen befindlichen Teiles der ersten Elektrode) zwischen den erwähnten Elementen erreichbar ist.

Die vorliegende Erfindung beruht auf einem von den Erfindern überraschenderweise entdeckten Effekt einer abnormalen sprunghaften Senkung und einer Entfernung eines Streuwertes des inneren Scheinwiderstandes der pn-Übergänge in Halbleitergeräten bei der Vereinigung der p- und der n-Gebiete und als Folge davon der pn-Übergänge durch Schaltung von an die Gebiete mit gleichnamiger Leitfähigkeit angrenzenden Kontakten und stromleitenden Abschnitten (Elementen) einer Elektrode zu einem parallelen Stromkreis und durch deren Vereinigung zu einer gemeinsamen Strombaugruppe (Elektrode) mittels einer Stromschiene.

Der Effekt der sprunghaften Senkung des Scheinwiderstandes und dessen Komponenten (des Wirkwiderstandes RB_{A, B}, der Induktivität L und der Kapazität C) in dem durch die stromleitenden Abschnitte einer ersten Elektrode gebildeten Parallelkreis praktisch auf Null erbringt eben, wie nachstehend erläutert wird, eine Erweiterung des Arbeitsfrequenzbereiches, eine Stabilität der elektrischen Werte und einen Anstieg der Leistung und des Wirkungsgrades von Halbleiterwandlern sowie eine bessere Standfestigkeit gegenüber den äusseren Einflußfaktoren (Radiation, Temperatur, Frequenzen od. dgl.). Dank einer Senkung des Scheinwiderstandes RB_{pB} des Wandlers praktisch auf Null vermag eine elektromagnetische Welle mit ausreichend geringer Frequenz fotovoltaische Effekte an den pn-Übergängen zu bewirken. Um fotovoltaische Effekte, also die Trennung von Ladungen und die Bildung von Elektronen-Löcher-Paare, zu bewerkstelligen, macht es sich erforderlich, einen Halbleiterwerkstoff mit entsprechender Breite der verbotenen Zone ΔE zu wählen. Praktisch reicht für herkömmliche Halbleiter wie Silizium, Gallium- oder Germaniumarsenid, wie oben angegeben, die Breite der verbotenen Zone für die Umwandlung selbst der Wellen aus dem üblichen UKW-Funkbereich aus.

Wenn man von dem heute bestehenden üblichen Auflösungsvermögen der Fotolithografie ausgeht, kann der Durchmesser von Zellenfenstern in Fotoschablonen für die Einbringung (Diffusion) von Beimengungen und zur Bildung von pn-Übergängen bei kreisförmiger Konfiguration zwischen 1 und 2 µm liegen. Entsprechend wird die Fläche S des pn-Überganges durch diese Grösse beschränkt, d. h. S = πR² = 3,14 µm, wobei die Dicke bevorzugt 50 bis 60 µm ausmacht.

Im Idealfall beläuft sich die Grösse des pn-Überganges vorteilhafterweise auf mindestens 1 bis 2 µm. Entsprechend den von den Urhebern dieser Erfindung gewonnenen Versuchsergebnissen ist die Streuung der Werte des inneren Widerstandes der pn-Übergänge desto höher, je kleiner das geometrische Maß der letzteren und der daran angrenzenden Diffusionsgebiete ist. Und je grösser die Streuung und die Zahl N der pn-Übergänge sind, desto höher ist die Wahrscheinlichkeit dessen, dass in dieser Auswahl pn-Übergänge mit ihrem inneren Widerstand von Null oder ca. Null enthalten sind. Wenn die Elemente, die Widerstände der pn-Übergänge sind, zu einem Parallelkreis zusammengeschlossen und zu einer einheitlichen Strombaueinheit mittels einer Schiene vereingt sind, liegt dann der Gesamtwiderstandswert gemäss dem Shunt-Gesetz unterhalb des geringsten Widerstandswertes eines Einzelelementes des Stromkreises (d. h. unterhalb des ermittelten geringsten Widerstandswertes, durch den ein oder mehrere pn-Übergänge im Stromkreis charakterisiert sind). Ausserdem nimmt bei solchen statistischen Auswahlen die Dispersion der Widerstandswerte umgekehrt proportional zu der Zahl der pn-Übergänge ab, d. h. je grösser die Zahl N der pn-Übergänge bei diesen Auswahlen ist, desto kleiner ist die Dispersion der Widerstandswerte und desto stabiler sind die elektrischen Daten eines solchen Halbleitergerätes.

Daher soll gemäss der Erfindung in Halbleiterstrukturen bei deren Herstellung eine ziemlich hohe Anzahl von pn-Übergängen mit ausreichend kleinen geometriaschen Maßen verwendet werden. Um ausserdem den grössten Effekt bei der Senkung des Widerstandes und dessen Streuwertes erreichen zu können, sollen die pn-Übergänge als einzeln und gleichartig ausgebildet sein, während der Durchmesser der pn-Übergänge (bei einer kreisförmigen Konfiguration des Diffusionsgebites bzw. der Schicht) bevorzugt mindestens dB_{0 B} = 1 bis 2 µm beträgt. Wenn in bezug auf die Fläche umgerechnet wird, soll dann die Querschnittsfläche eines einzelnen pn-Überganges bevorzugt (aber nicht unbedingt) weniger als S = 3,14 µm² und die Dicke weniger als 60 µm sein. Auf Grund der eingeschränkten Möglichkeiten der herkömmlichen Fotolithografie kann jedoch z. Z. die wirkliche Grösse der pn-Übergänge zwischen 2 und 5 und darüber sichergestellt werden. In diesem Fall bedarf man einer ziemlich hohen Anzahl N von pn-Übergängen N >> 1.

Um folglich den Effekt einer abnormalen Senkung des Widerstandes im inneren Stromkreis einer Halbleiter-Diodenstruktur zu verbessern, ist es notwendig, dass die Zahl der pn-Übergänge eine unendlich hohe Zahl, also N → ∞, anstrebt und dass diese Übergänge gleichartig sind, damit sie einzeln sind, während die Längenmaße (z. B. der Durchmesser im Falle einer kreisförmigen Konfiguration eines Diffusionsgebietes, also eines pn-Überganges) jedes von N pn-Übergängen ausreichend gering sind und im Idealfall das Minimum anstreben, d . h. dB_{0 B} → δ (wobei δ eine unendlich kleine Grösse ist).

Unter Beachtung der aufgeführten Bedingungen in einem erfindungsgemässen Wandler mit einer Diodenstruktur strebt der innere Scheinwiderstand der pn-Übergänge, wie das nachstehend gezeigt wird, nach einem Mindestwert (Nullwert). Dies ist auf die Senkung der Wirkkomponente R (R → 0), der kapazitiven Komponente C (C → 0) und der induktiven Komponente (L→ 0) des Scheinwiderstandes RB_{pB} der pn-Übergänge zurückzuführen. Der Gütewert Q eines solchen Wandlers strebt bei einer Erhöhung der Zahl N (N→ ∞) der pn-Übergänge nach einer hinreichend hohen Grösse. Als Folge hiervon steigen die Arbeitsgrenzfrequenz und die Temperaturbeständigkeit der elektrischen Daten mit der Abnahme der Grössen R, C und L wesentlich an. Die Temperaturbeständigkeit vergrössert sich bis zu einer Temperatur, die nahe derselben der Destruktion oder der Bildung eines pn-Überganges in einem Halbleiter ist. Infolge dessen, dass der Scheinwiderstand zurückgeht, steigt die Leistung des Wandlers an. Somit kann durch eine Erhöhung der Zahl N und eine Verringerung der geometrischen Maße von einzelnen pn-Übergängen ein Wandler geschaffen werden, der mit einer hinreichend hohen Arbeitsfrequenz f, einer hohen Ausgangsleistung und Temperaturbeständigkeit der elektrischen Werte betreibbar ist.

Es sei weiters angemerkt, dass bei solch einer Ausführung des Wandlers für dessen Bau das herkömmliche technische Silizium verwendbar ist, welches es gestattet, besser die Vorteile der beanspruchten Erfindung zu realisieren, weil es insbesondere eine hohe Streuung von physikalischen Eigenschaften verursacht, wodurch erfindungsgemäss eine bessere Möglichkeit für die Stabilisierung und Regelung der Eigenschaften dieses Werkstoffes im Vergleich zu reinen Werkstoffen, die keine beträchtliche Streuung von Eigenschaften hervorrufen, gegeben wird. Ausserdem ist es auch ausschlaggebend, dass der Preis für das gewöhnliche technische Silizium mehrfach so gering ist wie derselbe des "reinen" Siliziums, das extra für den Bau von herkömmlichen Solarzellen vorgesehen ist.

### Kurze Beschreibung der Zeichnungen

Die Erfindung wird nachtehend unter Bezugnahme auf die beigelegten Zeichnungen näher erläutert, in denen zeigen :
Fig. 1 ein Strukturbild eines erfindungsgemässen Wandlers ;
Fig. 2 ein Fragment eines erfindungsgemässen Wandlers, bestückt mit kristallinem Silizium auf Grundlage eines Substrats mit einer p-Schicht und einer Elektrode, welche die Gebiete mit gleichnamiger Leitfähigkeit (n-Gebiete) über den Umfang umgreift (eine Ansicht im Schnitt); ein Beispiel für eine quadratische Form der Gebiete mit gleichnamiger Leitfähigkeit (n-Diffusionsgebiete) ;
Fig. 3 dasselbe wie in Fig. 2, eine Draufsicht ;
Fig. 4 ein Fragment eines erfindungsgemässen Wandlers, bestückt mit kristallinem Silizium auf Grundlage eines Substrats mit einer n-Schicht und einer Elektrode, welche die Gebiete mit gleichnamiger Leitfähigkeit (p-Gebiete) über den Umfang umgreift (eine Ansicht im Schnitt);
Fig. 5 dasselbe wie in Fig. 4, eine Draufsicht ;
Fig. 6 ein Element der empfindlichen Fläche des in Figuren 2 bis 4 gezeigten Wandlers (pyramidale Flächen, die eine elektromagnetische Strahlung direkt aufnehmen) ;
Fig. 7 ein Fragment eines erfindungsgemässen Wandlers auf Grundlage eines Substrats mit einer p-Leitung und einer Elektrode, welche die Gebiete mit gleichnamiger Leitfähigkeit vollständig abdeckt, sowie rechteckigen stromleitenden Abschnitten an den Stellen der Anlage an die genannten Gebiete (eine Ansicht im Schnitt);
Fig. 8 dasselbe wie in Fig. 7, eine Draufsicht; mit gestrichelten Linien ist eine rechteckige Form der Gebiete mit gleichnamiger Leitfähigkeit (der Diffusionsgebiete) eingezeichnet ;
Fig. 9 ein Fragment eines in ähnlicher Weise wie in Fig. 7 ausgestalteten Wandlers mit durchgehenden Öffnungen in den Elektrödenabschnitten, die die Gebiete mit gleichnamiger Leitfähigkeit abdecken, sowie in dem Elektrodenabschnitt, durch welchen die erwähnten Anlagestellen mit den Gebieten mit gleichnamiger Leitfähigkeit verbunden werden (eine Ansicht im Schnitt) ; ein Beispiel für ein Fragment einer ersten Netzelektrode ;
Fig. 10 dasselbe wie in Fig. 9, eine Draufsicht; mit gestrichelten Linien ist ein rechteckiges Gebiet mit gleichnamiger Leitfähigkeit (ein Diffusionsgebiet) eingezeichnet ;
Fig. 11 ein Fragment eines in ähnlicher Weise wie in Fig. 7 ausgebildeten Wandlers mit linearen Abschnitten, die die Gebiete mit gleichnamiger Leitfähigkeit abdecken (eine Ansicht im Schnitt); ein Beispiel für ein Fragment einer ersten Streifenelektrode ;
Fig. 12 dasselbe wie in Fig. 11, eine Draufsicht ; mit gestrichelten Linien sind quadratische Gebiete mit gleichnamiger Leitfähigkeit (Diffusionsgebiete) eingezeichnet;
Fig. 13 ein Fragment eines in ähnlicher Weise wie in Fig.7 ausgebildeten Wandlers mit polygonalen (zwölfeckigen) Abschnitten, die die Gebiete mit gleichnamiger Leitfähigkeit abdecken, (eine Ansicht im Schnitt); ein Beispiel für ein Fragment einer ersten polygonalen Streifenelektrode ;
Fig. 14 dasselbe wie in Fig. 13, eine Draufsicht ; die polygonale Form des Elektrodenabschnittes (-elementes) stimmt voll mit der Form des Diffusionsgebietes 2 überein;
Fig. 15 ein Fragment eines in ähnlicher Weise wie in Fig. 13 ausgebildeten Wandlers mit durchgehenden (schlitzförmigen) Öffnungen in den Abschnitten, die unmittelbar an die Gebiete mit gleichnamiger Leitfähigkeit angrenzen und diese abdecken (eine Ansicht im Schnitt);
Fig. 16 dasselbe wie in Fig. 15, eine Draufsicht ;
Fig. 17 ein Beispiel für eine günstige Anordnung von (zwölfeckigen) Gebieten mit gleichnamiger Leitfähigkeit (eine Mikroaufnahme der Wandleroberfläche) ;
Fig. 18 Variationsdiagramme für die Verteilung der Widerstandswerte R von einzelnen gleichartigen pn-Übergängen entsprechend den Reihenfolgenummern **n** für Muster der Silizium-Wandler bei einer Frequenz f von 1 kHz ;
Fig. 19 Variationsdiagramme für die Verteilung der Widerstandswerte R von einzelnen gleichartigen pn-Übergängen im Ruhezustand für Bezugswandler (serienmässige Fotodioden Φ 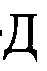 263-01) und für die Verteilung der Widerstandswerte der pn-Übergänge in erfindungsgemässen Wandlern ;
Fig. 20 Variationsdiagramme für die Verteilung der Widerstandswerte R von einzelnen gleichartigen pn-Übergängen der Bezugswandler (K 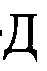 243) und der erfindungsgemässen Wandler bei verschiedenen Arbeitsfrequenzen ;
Fig. 21 Variationsdiagramme für die Verteilung der Kapazitätswerte C von pn-Übergängen der Bezugswandler K 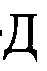 243 und der erfindungsgemässen Wandler bei verschiedenen Arbeitsfrequenzen.

Die beigelegten Zeichnungen sind mit folgenden Bezugszeichen versehen :
1 - ein pn-Übergang ;
2 - eine n-Schicht ;
2A - lichtempfindliche pyramidale Flächen ;
3 - eine p-Schicht ;
4 - eine pP^{+P}-Schicht (eine hochdotierte p-Schicht) ;
4A - eine nP^{+P}-Schicht (eine hochdotierte n-Schicht) ;
5 - eine positive Elektrode (Anode) ; Bestandteile der Elektrode sind eine Schiene 11 und stromleitende Elemente 9 ;
6 - eine negative Elektrode (Kathode) ; Bestandteile der Elektrode sind eine Schiene 11 und stromleitende Elemente 9 ;
7 - eine Isolierschicht ;
8 - ein elektromagnetischer Fluß (Lichtfluß) ;
9 - stromleitende Abschnitte (Elemente) der Elektrode 6 (bzw. 5) ;
10 - eine durchgehende Öffnung in Form eines Ausschnittes (eine dielektrische Zwischenlage oder ein Trenner zum Trennen von stromleitenden Elektrodenelementen voneinander od. dgl.) ;
11 - eine Stromschiene, welche die stromleitenden Elemente 9 der Elektroden 6 (oder 5) zu einer Strombaueinheit (Elektrode) zusammenfasst ;
12 - eine Verteilung der Widerstandswerte von pn-Übergängen entsprechend den Reihenfolgenummern n, welche Verteilung ausgehend von den Versuchsergebnissen einer Serie von gleichen Mustern der Silizium-Wandler mit nur einem pn-Übergang N = 1 mit einer Fläche von 300 µm² ermittelt wurde ; die Meßdaten sind bei einer Frequenz von 1 kHz gewonnen ;
13 - eine Verteilung der Widerstandswerte von pn-Übergängen entsprechend den Reihenfolgenummern n, welche Verteilung ausgehend von den Versuchsergebnissen einer Serie von gleichen Mustern der erfindungsgemässen Silizium-Wandler mit N = 100 pn-Übergängen, welche mittels parallel geschalteter, an die Gebiete mit gleichnamiger Leitfähigkeit angrenzender Elektroden zusammengefasst sind, ermittelt wurde, wobei sich die Fläche jedes der pn-Übergänge auf 300 µm² beläuft ; die Meßergebnisse sind bei einer Frequenz von 1 kHz erhalten ;
14 - eine Verteilung der Widerstandswerte von pn-Übergängen entsprechend den Reihenfolgenummern n, die ausgehend von den Versuchsergebnissen einer Serie von gleichen Mustern der Wandler mit nur einem pn-Übergang N=1 mit einer Fläche von 30 µm² ermittelt wurde ; die Meßergebnisse sind bei einer Frequnz von 1 kHz erhalten ;
15 - eine Verteilung der Widerstandswerte von pn-Übergängen entsprechend den Reihenfolgenummern n, welche Verteilung ausgehend von den Versuchsergebnissen einer Serie von gleichen Mustern der erfindungsgemässen Wandler mit N = 100 pn-Übergängen, welche mittels parallel geschalteter, an die Gebiete mit gleichnamiger Leitfähigkeit angrenzender Elektroden zusammengefasst sind, ermittelt wurde; die Fläche jedes der pn-Übergänge beläuft sich auf 30 µm² ; die Meßergebnisse sind bei einer Frequenz von 1 kHz erhalten ;
16 - eine Verteilung der Widerstandswerte, welche ausgehend von den Versuchsergebnissen von Bezugs-Fotodioden Φ 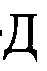 263-01 mit nur einem pn-Übergang N=1 ermittelt wurde ; die Meßergebnisse sind bei einer Frequenz von 1 kHz erhalten ;
17 - eine Verteilung der Widerstandswerte, welche ausgehend von den Versuchsergebnissen der erfindungsgemässen Wandler mit einer Zahl N von pn-Übergängen ermittelt wurde, welche pn-Übergänge mittels parallel geschalteter, an die Gebiete mit gleichnamiger Leitfähigkeit angrenzender Elektroden bei N = 2 zusammengefaßt sind; die Meßergebnisse sind bei einer Frequenz von 1 kHz gewonnen;
18 - dasselbe wie in Fig. 17, jedoch N=4 ;
19 - dasselbe wie in Fig. 17, jedoch N=8 ;
20 - dasselbe wie in Fig. 17, jedoch N=200 ;
21 - eine Verteilung der Widerstandswerte, die ausgehend von den Versuchsergebnissen von serienmässig gebauten Bezugswandlern K 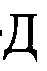 243, von denen jeder nur einen pn-Übergang N=1 aufwies, bei Anwendung einer Arbeitsfrequenz f = 1 kHz ermittelt wurde;
22 - dasselbe wie in Fig. 21, jedoch bei einer Arbeitsfrequenz f = 10 kHz ;
23 - eine Verteilung der Widerstandswerte, welche ausgehend von den Versuchsergebnissen der erfindungsgemässen Wandler mit einer Zahl N von pn-Übergangen , die mittels parallel geschalteter, an die Gebiete mit gleichnamiger Leitfähigkeit angrenzender Elektroden bei N = 4 zusammengefasst sind, bei N = 4 und einer Arbeitsfrequenz f = 1 kHz ermittelt wurde ;
24 - dasselbe wie in Fig. 23, jedoch N = 4 und f = 10 kHz ;
25 - dasselbe wie in Fig. 23, jedoch n = 200 und f = 1 kHz ;
26 - dasselbe wie in Fig. 23, jedoch N = 200 und f = 10 kHz ;
27 - eine Verteilung der Kapazitätswerte C von pn-Übergängen, die ausgehend von den Versuchsergebnissen einer Serie von serienmässig gebauten Bezugswandlern K 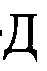 243, von welchen jeder nur einen pn-Übergang aufwies, bei einer Frequenz f = 1 kHz ermittelt wurde;
28 - dasselbe wie in Fig. 27, jedoch f = 10 kHz ;
29 - eine Verteilung der Kapazitätswerte C von pn-Übergängen, die ausgehend von den Versuchsergebnissen einer Serie von gleichen erfindungsgemässen Wandlern, von denen jeder N pn-Übergänge hatte, bei N = 4 und einer Frequenz f = 1 kHz ermittelt wurde ;
30 - dasselbe wie bei 29, jedoch N = 8 und f = 10 kHz ;
31 - dasselbe wie bei 29, jedoch N = 16 und f = 10 kHz ;
32 - dasselbe wie bei 29, jedoch N = 20 und f = 1 kHz.

### Bevorzugte Ausführungsformen der Erfindung

Fig. 1 zeigt ein Strukturbild eines erfindungsgemässen Wandlers. Auf der oberen, einen elektromagnetischen Strahlungsfluß 8 aufnehmenden Fläche eines planen Substrates 3 (insbesondere aus technischem kristallinem Silizium), welches wegen der Eindringung von Beimengungen eine p-Leitung (was insbesondere durch die Eindringung der Beimengungen von dreiwertigem Bor oder eines anderen dreiwertigen Diffusantes) oder eine n-Leitung (wegen der Eindringung von insbesobere fünfwertigem Phosphor, Arsen oder einem anderen fünfwertigen Diffusant) aufweist, werden bei Anwendung von bei der Halbleitertechnik üblichen Methoden (unter Einsatz von Fotoschablonen) Beimengungen unter Bildung von N nach der Zusammensetzung, den Maßen und anderen Charakteristiken gleichartiger Gebiete 2 mit gleichnamiger, der Leitfähigkeit des Substrates entgegengesetzter Leitfähigkeit eingebracht. Die Gebiete 2 sollen in beliebiger bekannter Weise voneinander getrennt sein (sie sollen z. B. auf der Substratfläche verteilt werden, derart, dass keine gemeinsamen Grenzen und sich überschneidenden Abschnitte vorliegen, voneinander unter Einsatz einer isolierenden Oxidschicht 7 getrennt sind, usw.). Entsprechend enstehen nach Bildung einzelner gleichartiger Gebiete 2 mit gleichnamiger Leitfähigkeit auch N einzelne gleichartige pn-Übergänge. Danach werden z. B. mit Hilfe der Fotolithografie auf die obere Substratseite eine erste Elektrode 6 und auf die Rückseite des Substrates in ähnlicher Weise eine zweite Elektrode 5 aufgebracht.

Wie aus Figuren 2 bis 5 erkennbar ist, weist die erste Elekrode 6 gemäss einer besonderen Ausführungsform der Erfindung Abschnitte, die die Gebiete 2 mit gleichnamiger Leitfähigkeit über deren Umfang umgreifen, und eine diese Abschnitte verbindende Stromschiene 11 auf. Im vorliegenden Fall wird der elektromagnetische Strahlungsfluß 8 direkt von den Gebieten 2 aufgenommen.

Die Elektroden 5, 6 und die Schiene 11 können aus einem beliebigen, in der Halbleitertechnik geläufigen stromleitenden Werkstoff (wie Silber, Aluminium, Kupfer usw.) in der Form einer Schicht, eines Filmes oder von Drähten bestehen und jeweils durch eine beliebige bekannte Methode, wie z. B. ein mehrlagiges Aufdampfen, hergestellt werden.

Im Beispiel gemäss Figuren 2 und 3 benutzte man für die Fertigung eines Wandlers ein Substrat 3 mit einer p-Leitung, indem die Gebiete 2 jeweils n-Gebiete waren. Das Fragment des Wandlers gemäss Figuren 2 und 3 besitzt vier n-Gebiete und jeweils vier pn-Übergänge, und es versteht sich von selbst, dass der gesamte Wandler eine viel grössere Zahl N der Gebiete 2 und der pn-Übergänge 1 (je nach der Grösse des Substrates 3, der Gebiete 2 und der pn-Übergänge 1 kann die Zahl N mehr als 1, 2, 3, 4, 5, 6, 7, 8, 16, 100, 1000, 10000, 100000, 1000000 usw. sein) haben kann, welche in ähnlicher Weise wie in Figuren 2 und 3 ausgestaltet und faktisch zu einem Parallelstromkreis geschaltet und zu einer Strombaueinheit mittels der Elektrode 6 (und der daran angrenzenden Gebiete 2 und der Stromschiene 11) zusammengeschlossen sind. Insbesondere wurden bei der Herstellung eines in Figuren 2 und 3 gezeigten Wandlers auf einem Substrat mit einer Grösse von 60 mm x 60 mm und einer Dicke von 270 µm 200000 n-Gebiete 2 (bei einer Grösse der Diffusionsgebiete von 50 µm x 50 µm = 2500 µm²) und jeweils die gleiche Zahl von pn-Übergängen 1 (diese sind eine Gruppe aus 50000 Fragmenten, die denen in Figuren 2 und 3 identisch sind) erhalten. Die Dicke jedes der n-Gebiete betrug dabei in etwa 3 µm. Die Gebiete 2 und jeweils die pn-Übergänge 1 sind mittels einer Isolierschicht 7 voneinander getrennt, die beispielsweise eine Schicht aus oxydiertem Silizium sein und auf das Substrat 3 im Bildungsvorgang der n-Gebiete aufgetragen werden kann.

Im beschriebenen Beispiel gemäss Figuren 2, 3 ist ausserdem auf der der Anordnung der Gebiete 2 gegenüberliegenden Seite eine zusätzliche Schicht 4 vorgesehen , welche eine im Vergleich zum Substrat 3 hochdotierte Schicht (im Beispiel gemäss Figuren 2 und 3 ist dies eine pP^{+P}-Schicht) mit einer höheren Konzentration von Diffusanten und somit mit einer höheren Dichte der Ladungsträger ist. Als Folge der Bildung dieser Schicht baut sich ein zusätzliches elektrisches Innenfeld zwischen dem p-Substrat 3 und der pP^{+P}-Schicht 4 auf, so dass die Bewegung der Ladungsträger zur Elektrode 5 hin erleichtert wird und deren Rekombination auf dem Laufweg zum äusseren Stromkreis abnimmt.

Die besondere Ausführungsform gemäss Figuren 4 und 5 unterscheidet sich von dem vorigen Beispiel nur noch dadurch, dass bei der Fertigung eines Wandlers ein Substrat 2 mit einer n-Leitung eingesetzt wird. Entsprechend haben die Gebiete 3 eine p-Leitung und die hochdotierte Schicht 4A ist eine pP^{+P}-Schicht (mit einer n-Leitung).

Obwohl dies in Zeichnungen direkt nicht eingezeichnet ist, sei angemerkt, dass sich im Rahmen der vorliegenden Erfindung verschiedene besondere Ausführungsformen der Elektrode 5 anbieten, die an das Gebiet mit entgegengesetzter Leitfähigkeit (unmittelbar an das Substrat 3 oder die hochdotierte Schicht 4) angrenzt. So lässt sich z. B. statt der einzigen Massivelektrode 5 eine der Elektrode 6 ähnliche Elektrode (aus Streifenabschnitten, die mittels einer Stromschiene miteinander verbunden sind) hergestellen. Die Zahl L solcher Streifenabschnitte der Elektrode 5 kann beliebig groß sein, es ist aber bevorzugt, dass sie die Zahl N der Gebiete 2 mit gleichnamiger Leitfähigkeit nicht übertriftt. Wenn L = N ist, werden die Streifenabschnitte der Elektrode 5 auf der unteren Seite des Substrates unmittelbar gegenüber den Gebieten 2 vorteilerhafterweise angeordnet, um die minimale (kürzeste) Laufbahn von Ladungen sicherzustellen und somit die Wahrscheinlichkeit deren Rekombination oder Absterben zu mindern. Die Zahl L der Streifenabschnite der Elektrode 5 kann auch die Zahl N der Gebiete 2 übertreffen, jedoch können sich die Kenndaten des Wandlers in diesem Fall infolge einer dabei nicht günstigen Laufbahn der Ladungen sowie gleichzeitig wegen eines Anstieges des Widerstandes an der Elektrode 5 (darunter auch eines Kontaktwiderstandes, hervorgerufen unmittelbar durch den Anstieg der Zahl der Streifenabschnitte) im Vergleich zum Fall L ≤ N verschlechtern, so dass ein solcher besonderer Fall zwar möglich ist, gilt er aber nicht als bevorzugt.

Um die empfindliche, eine elektromagnetische Strahlung absorbierende Oberfläche des Wandlers zu vergrössern, kann diese Oberfläche im Rahmen der vorliegenden Erfindung nicht als flach ausgebildet, sondern bestehend aus einer Gesamtheit von dreidimensionalen Raumelementen, insbesondere, wie dies in Fig. 2, vorzugsweise in Fig. 6 erkennbar ist, aus pyramidalen Elementen 2A, die durch die Fotolithografie und einen Ätzvorgang herstellbar sind, sein. Der Fachmann weiß jedoch Bescheid, dass anstelle der in Fig. 6 gezeigten pyramidalen Elemente für die Vergrösserung der empfindlichen Oberfläche eines Wandlers auch andere dreidimensionale Elemente geeignet sind.

Figuren 7 bis 16 zeigen weitere besondere Ausführungsformen der Erfindung, bei denen für eine Abnahme der Rekombination der Elektronen-Löcher-Paare, die unter Einwirkung eines elektromagnetischen Strahlungsflusses auf das lichtempfindliche Gebiet des Wandlers entstanden sind, und somit für eine bessere Wirksamkeit der Energieumwandlung erfindungsgemäss eine besondere Konstruktion der ersten Elektrode 6 vorgesehen ist. Hierbei umfasst die erste Elektrode 6 oberhalb der Diffusionsgebiete 2 angeordnete Abschnitte 9, die den gesamten pn-Übergang vollständig oder teilweise abdecken. Dabei stimmt die Konfiguration der an die Diffusionsgebiete 2 direkt angrenzenden Abschnitte 9 der Elektrode 6 bevorzugt mit derselben dieser Gebiete überein. Als Folge davon trifft der elektromagnetische Fluß in den in Figuren 7 bis 16 gezeigten Beispielen auf den pn-Übergang 1 unmittelbar über den Umfang der gezeigten Abschnitte 9 der Elektrode 6 auf. Einzelne Arten der vorgeschlagenen Konstruktion der Abschnitte 9 mit durchgehenden Öffnungen 10 (oder Oxidspalten oder einem anderen Trenner) gestatten es auch, einen parasitären Kontaktwiderstand und die Kapazität an den unmittelbaren Stellen des Kontaktes der Elektroden und anderer stromleitendet Teile mit dem Halbleiter zu mindern.

Im Beispiel gemäss Figuren 7 und 8 umfasst die erste Elektrode 6 unmittelbar an die Gebiete 2 mit gleichnamiger Leitfähigkeit angrenzende und oberhalb davon angeordnete Abschnitte 9, die durch stromleitende Streifenabschnitte mit kleinerer Breite miteinander verbunden sind, und eine Stromschiene 11, zu welcher die angegebenen stromleitenden Streifenabschnitte kleinerer Breite zugeleitet sind. Diese Ausgestaltung der Elektrode 6 und insbesondere die Anordnung deren Abschnitte 9 unmittelbar oberhalb des Diffusionsgebietes gestatten es, die Rekombination von entstandenen Elektronen-Löcher-Paaren zu verringern und somit die Anzahl der dem äusseren Stromkreis zugeführten Ladungen zu vergrössern, d. h. den Fotostrom zu verstärken.

Ähnliche Ergebnisse werden bei einer anderen Konfiguration der Gebiete 2 im Beispiel gemäss Figuren 11 und 12 erzielt, das sich von dem vorstehend beschriebenen Beispiel dadurch unterscheidet, dass die Abschnitte 9 selbst als Streifenabschnitte ausgestaltet sind und gleichzeitig mehrere Gebiete 2 abdecken.

Das Ausführungsbeispiel eines Wandlers gemäss Figuren 13 und 14 ist im wesentlichen dem oben beschriebenen ähnlich, wobei jedoch der Nutzeffekt der Energieumwandlung dieses Wandlers durch eine Verstärkung des Innenfeldes der pn-Übergänge 1 anwächst, was der optimalen Konfiguration der Abschnitte 9 der Elektrode 6 und solcher der Diffusionsgebiete zu verdanken ist.

In der Tat nimmt die Umfangslänge des Diffusionsgebietes je nach der Konfiguration der an die Gebiete 2 angrenzenden Abschnitte 9 der Elektrode 6 ab oder zu. Dies ergibt sowohl eine Abnahme der Grösse des elektrischen Innenfeldes des pn-Überganges 1, als auch dessen Verstärkung. Bei gleicher Fläche verschiedener Figuren wird der längste Umfang des pn-Überganges bei einer polygonalen Konfiguration (insbesondere bei einem Zwölfeck gemäss Fig. 14) erzielt. Diese zwölfeckige Form des Abschnittes 9 sorgt bei der gleichen Fläche der Figuren verschiedener Konfigurationen für den höchsten Umfangswert des Diffusionsgebietes. Daher weist das durch den pn-Übergang 1 erzeugte elektrische Innenfeld bei Wandlern mit einer solchen Struktur der Diffusionsgebiete einen viel höheren Wert auf, wodurch naturgemäss das Niveau der Rekombination von Ladungen zusätzlich gesenkt und deren Wanderung zum äusseren Stromkreis erleichtert wird. Es sei dabei betont, dass sich in der Praxis auch andere Formen (sechs- und achteckige, wie auch andere beliebige, verfahrenstechnisch realisierbare Formen, die bei der minimalen Fläche des Gebietes 2 für die Diffusion von Beimengungen den grössten Umfang des pn-Überganes sichern können) der Abschnitte 9 der Elektrode 6 anbieten, wobei für jeden Anwendungsfall eine konkrete Form des Abschnittes 9 ausgehend von den Maßen der Gebiete 2 und der Dichte deren Anordnung auf dem Substrat 3 ausgewählt werden kann.

Hinzu kommt, dass bei der Auswahl einer konkreten Ausgestaltung der Elektrode 6 darauf geachtet werden soll, dass bei Halbleitergeräten Widerstands- und Kapazitätswerte an den Stellen eines direkten Kontaktes der Elektrode mit dem Halbleiter (der Kontaktwiderstand und die Kapazität) einen grösseren Wert erreichen. Daher wird im Rahmen der vorliegenden Erfindung vorgeschlagen, die Kontaktfläche der Strombahnen (insbesondere der Elektrode 6 oder der Elektrode 5) beim Kontakt mit dem Halbleiter zu mindern.

So ist insbesondere bei den Beispielen gemäss Figuren 9, 10 und 15, 16 die Form der Abschnitte 9 der Elektrode 6, welche Abschnitte an die Gebiete 2 mit gleichnamiger Leitfähigkeit angrenzen und diese gegen einen Fluß der elektromagnetischen Strahlung 8 schützen, der Form der Abschnitte 9 bei den bereits beschriebenen Beispielen (die jeweils in Figuren 7, 8 und 13, 14 gezeigt sind) ähnlich. Der Unterschied besteht darin, dass bei diesen Beispielen zur Senkung des Kontaktwiderstandes und der Kapazität vorgeschlagen wird, in die die Gebiete 2 abdeckenden Abschnitte 9 die Zahl M > 1 der parallel geschalteten und zu einer Strombaueinheit zusammengefassten, gleichartigen Einzelelemente zu integrieren. Die in den Beispielen gemäss Figuren 9, 10 und 15, 16 angegebenen gleichartigen Elemente der Abschnitte der ersten Elektrode haben eine Streifenform und sind voneinander (in Figuren 15 und 16 auch von den benachbarten Teilen eines zwölfeckigen Abschnittes 9 der ersten Elektrode) mittels einer Zahl K der durchgehenden Öffnungen (Durchbrüche in der Bahn der ersten Elektrode) oder alternativ von Oxidspalten 10 (oxidierten Abschnitten der ersten Elektrode) getrennt, wobei 1 < K ≤ (M + 1) ist.

Die angegebenen Elemente der Elekrode 9 und die durchgehenden Öffnungen (Oxidspalte) 10 sind direkt in der Abdeckzone zum Abdecken der Gebiete 2 gelegen. Die genannten durchgehenden Öffnungen (Spalte) 10 können im allgemeinen eine beliebige Form der Kante im Grundriß aufweisen, sie sind jedoch in den dargestellten Beispielen im wesentlichen quadratisch (Fig. 10) und schlitzförmig (Fig. 16) ausgestaltet. Um ausserdem den Kontaktwiderstand und die Kapazität im Bereich der Schiene 11 zu mindern, können darin, wie in Fig. 10 gezeigt, ebenfalls durchgehende Öffnungen 10 (bei diesem Beispiel sind das rechteckige Öffnungen) vorgesehen werden, obwohl es nicht verbindlich ist ( in Fig. 16 besitzt die Schiene 11 keine Öffnungen). Bei den in Figuren 9, 10 und 15, 16 gezeigten Ausführungsbeispielen der Elektrode 6 geschieht im Vergleich zu den vorstehend beschriebenen ähnlichen Ausführungsbeispielen ohne Öffnungen (Spalte) 10 gleichzeitig mit der Verminderung der Rekombination von Ladungen auch eine Senkung des Widerstandes und der elektrischen Kapazität des Wandlers, so dass der Fotostrom zusätzich verstärkt und der Wirkungsgrad des Gerätes verbessert wird.

Es sei angemerkt, dass bei sämtlichen Beispielen für den Bau von Wandlern nicht nur eine sinnvolle Konfiguration und Form der Abschnitte 9 der ersten Elektrode, sondern auch deren Anordnung auf dem Substart 3 eines Halbleiterkristalls ausgewählt werden soll, wobei ein optimaler Abstand zwischen den Abschnitten 9 der ersten Elektrode und den Grenzen der Diffusionsgebiete 2 ausschalggebend ist. So ist z. B. in Fig. 17 eine Variante für eine günstige Anordnung von zwölfeckigen ("großohrigen") Diffusionsgebieten 2 auf einem Halbleiterkristall gezeigt, bei der sich auf dem Substrat 3 eine maximale Anzahl von Gebieten 2 anordnen lässt.

Bei dem Beispiel mit einer großohrigen Konfiguration und Form der Diffusionsgebiete und der daran angrenzenden Abschnitte der Elektrode soll darauf verwiesen werden, dass bei dem Zwölfeck alle Seiten gleich einander sind, ausser zweier gegenüberliegender Seiten, die doppelt so groß sind, wie die gleichen Seiten (siehe Figuren 16, 17).

Es sei nochmals betont, dass die ans Gebiet mit entgegengesetzter Leitfähigkeit angrenzende Elektrode 5 in ähnlicher Weise wie die Elektrode 6 in den beschriebenen Beispielen aufgebaut werden kann (also bei einer Variation der Konfiguration deren Abschnitte in Abhängigkeit von der Form und der Anordnung der Gebiete 2 mit gleichnamiger Leitfähigkeit, incl. der vollen Nachahmung der Form der Elektrode 6 und der Herstellung von durchgehenden Öffnungen (Oxidspalten) in der Elektrode 5 zur Minderung des Kontaktwiderstandes und der Kapazität). Um Halbleiterwandler gemäss der Erfindung herzustellen, können standardisierte Halbleiterwerkstoffe mit üblichem Reinheitsgrad, wie z. B. gegenwärtig weit verbreitetes technisches Silizium, sowie eine herkömmliche Technologie für den Bau von Halbleitergeräten wie eine Epitaxie oder ein Diffusionsaufdampfen in Verbindung mit der herkömmlichen Fotolithografie (jedoch mit keiner Submikron-Fotolithografie ) eingesetzt werden. Als Folge davon kann der Investaufwand bei dem Bau neuer Halbleitergeräte im wesentlichen reduziert werden.

Experimentelle Beweise für die Erreichung eines technischen Ergebnisses sind in Figuren 18 bis 21 und der Tabelle 1 zusammengefasst.

Die Komponenten des Scheinwiderstandes der pn-Übergänge RB_{pB}, wie der Wirkwiderstand R, die Kapazität C und die Induktivität L, sind struktur-empfindliche Charakteristiken von Werkstoffen, so dass deren Erscheinungsform einer stochastischen (oder probabilistischen ) Art ist. Infolge dessen, dass R, C, L stochastische Werte sind, können deren Abweichungen in einem Werkstoff nur noch mittels statistischer Methoden ermittelt werden. Daher bedienten sich die Erfinder statistischer Methoden für den Nachweis der Erreichung eines technischen Ergebnisses. Bei der vorliegenden Erfindung besteht der Wandler faktisch aus einer statistischen Auswahl von N Elementen (pn-Übergängen). In Figuren 18 bis 21 und in Tabelle 1 sind statistische experimentelle Meßdaten für die Wirkwiderstände R, die Kapazität C, die Induktivität L und die Güte Q von pn-Übergängen bei verschiedenen Arbeitsfrequenzen f angeführt. Zur Sicherung der Verläßlichkeit, Aussagekraft und Reproduzierbarkeit der Ergebnisse wurden Serien (statistische Auswahlen) von pn-Übergängen gemessen, die aus mindestens 100 Mustern von Wandlern (Bezugswandlern, serienmäßig gebauten und erfindungsgemässen Wandlern) bestanden. Ausgehend von den Meßdaten von R, C, L und Q der pn-Übergänge wurden statistische Verteilungskurven in Form von integralen Verteilungskurven (oder Variations-Verteilungsdiagrammen, was dasselbe ist) dieser Werte entsprechend den Reihenfolgenummern n gezeichnet.

In Tabelle 1 sind Werte der Parameter R, C, L, Q für einen Bezugswandler mit einer Zahl N = 1, 10 und 1000 von einzelnen gleichartigen pn-Übergängen bei einer Frequenz f von 1 kHz und 1 MHz zusammengestellt.

**Tabelle 1**

| N | Frequenz f | | | | | | | |
|---|---|---|---|---|---|---|---|---|
| | 1 kHz | | | | 1 MHz | | | |
| | R, kOhm | C, nF | L, H | Q, Güte | R, Ohm | C, nF | L, H | Q, Güte |
| 4 | 4,87 | 404,5 | 0,0061 | 0,0182 | 4,911 | 0,152 | 0,0008 | 12,65 |
| 10 | 1,91 | 60,66 | 0,0011 | 0,167 | 0,411 | 0,012 | 0,0003 | 15,3 |
| 1000 | 0,0000 | 0,0000 | 0,0000 | ∞ | 0,0000 | 0,0000 | 0,0000 | ∞ |

Aus Fig. 18 ist ersichtlich, dass je nach der Grösse der Fläche S von pn-Übergängen der Widerstand R eine unterschiedlich hohe Streuung von Versuchsdaten aufweist. Bei einer statistischen Auswahl für massive pn-Übergänge ist die Streuung der Widerstandswerte viel geringer (Kurve 12), als bei einer Auswahl mit kleineren Werten der pn-Übergänge (Kurve 14). Die kleinen pn-Übergänge haben eine gewaltige Streuung und Dispersion von Widerstandswerten, und quantitativ beläuft sich die Streuung der Widerstandswerte auf einen Wert von 0 bis 0,2 Ohm und bei einer Auswahl mit grossen pn-Übergängen auf einen Wert von 0,05 bis 0,15 Ohm. Dabei werden bei einer statistischen Auswahl mit grossen (massiven) pn-Übergängen kleine Widerstandswerte, die beispielsweise nahe Null sind, gar nicht angetroffen, weil sie in dieser statistischen Auswahl einfach fehlen. Bei einer Auswahl mit kleinen Grössen der pn-Übergänge trifft man eine grosse Menge von Übergängen mit kleinen, nahe Null liegenden Werten an. Und wenn nun die den Kurven 12 und 14 entsprechenden Muster zu einem statistischen Bündel mit N = 100 durch deren Schaltung zu einem Parallelkreis mittels eines einzigen Leiters und dann zu einer Baueinheit zusammengefasst werden, tritt das gewünschte technische Ergebnis ein. In beiden Fällen wird die experimentelle Streuung bei der Vereinigung zu einem Bündel (einem Parallelkreis mit einziger Baueinheit) voll vermieden, der Gesamtwiderstand nimmt beachtlich ab, wird stabil und bewahrt seine Grösse über den gesamten Bereich der gemessenen Werte konstant (siehe Kurven 13 und 16). Dabei wird, wie dies aus den Kurven 13, 16 ersichtlich, der Gesamtwiderstand geringer als der geringste Wert. Jedoch bei einer statistischen Auswahl mit kleinen pn-Übergängen bleibt der Gesamtwiderstand viel geringer als bei einer Auswahl mit grossen pn-Übergängen und erlangt darin einen Nullwert. Insgesamt sieht das so aus, dass je kleiner die Grösse der pn-Übergänge und je grösser die Zahl N ist, desto stärker nimmt der Gesamtwiderstand der pn-Übergänge ab.

Somit ergibt sich aus den Angaben gemäss Fig. 18, dass bei der Herstellung eines erfindungsgemässen Halbleitergerätes die Grösse der pn-Übergänge bevorzugt klein sein soll, während die Zahl N ziemlich hoch ist (im Idealfall soll sie nach einer unendlich hohen Zahl streben).

Es ist besonders hervorzuheben, dass die Streuung der physikalischen Werte von Werkstoffen, insbesondere der (vorstehend beschriebenen) Widerstandswerte, nicht nur von dem Maßstab, der Temperatur oder der Belastung eines Musters, sondern auch von der Materialreinheit abhängig ist. Bei einem chemisch reinen Silizium ist die Streuung von Versuchsdaten unwesentlich und daher bleibt der Effekt der Senkung eines Widerstandswertes bei Inanspruchnahme von solchen Werkstoffen sehr gering. Für den Bau von erfindungsgemässen Wandlern ist ein herkömmliches technisches Silizium oder ein Galliumarsenid oder ein anderer Halbleiterwerkstoff, welcher eine ziemlich hohe Streuung von Versuchsdaten verursacht, bevorzugt. Bei Vorliegen einer hohen Streuung von Versuchsdaten ist ein Effekt einer beträchtlichen Senkung des Widerstandes im Parallelkreis möglich.

Den vorstehend aufgeführten Erkenntnissen ähnliche Daten wurden bei Versuchen gewonnen, bei denen als Bezugswandler serinenmässig gebaute Industriewandler zum Einsatz kamen (siehe Fig. 19). Aus der Kurve 16 gemäss Fig. 19 ist es ersichtlich, dass der Widerstand des pn-Überganges eines serienmässig gebauten Industriewandlers Φ 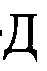 -263-01 mit nur einem Übergang (N=1) eine gewaltige experimentelle Grössenstreuung aufweist. Abgesehen von einer grossen Abmessung des pn-Überganges (die Fläche S des pn-Überganges machte 9 mm² aus) wurden jedoch bei einem Anstieg bis auf einen Wert von N = 2, 4, 8, 200 ein restloses Verschwinden der Streuung, eine Stabilisierung des Gesamtwiderstandswertes und dessen beachtliche Senkung auf Null beobachtet (siehe Kurven 16 bis 20 in Fig. 19). Um dennoch die Streuung zu beheben, sehr präzise Widerstandswerte zu gewinnen und den Widerstandswert zu vermindern, ist es notwendig, die Bedingungen einer Ungleichung N > 1 zu erfüllen, d. h. dass diese Zahl hinreichend groß und im Idealfall N → ∞ sein soll.

Die Ergebnisse einer experimentellen Forschung haben auch ergeben, dass bei einer statistischen Auswahl von N pn-Übergängen (welche zu einem elektrischen Parallelkreis mittels einer Elektrode 6 zusammengeschlossen sind) nicht nur die Werte des Wirkwiderstandes R, sondern auch die Werte der Induktivitäten L und Kapazitäten C stabil werden oder gar zurückgehen (siehe auch Figuren 20, 21 und Tebelle 1). Der Rückgang der Kapazität hängt damit zuusammen, dass sich infolge einer Senkung des Widerstandes die parasitäre Ladung an den pn-Übergängen nicht ansammelt, sondern zum äusseren Stromkreis wandert. Der Mechanismus für die Senkung der Induktivität ist demselben für die Senkung des Widerstandes im Parallelkreis ähnlich. Dabei sichert eine Senkung der Werte R, C, L ebenfalls eine beachtliche Erhöhung der Güte Q des Wandlers.

Hinzu kommt, dass bei einem gleichzeitigen Anstieg der Zahl N und der Arbeitsfrequenz f (siehe Kurven 10 bis 15 in Fig. 20 für den Widerstand und Kurven 27 bis 32 in Fig. 21 für die Kapazität) die Werte des Innenwiderstandes R, der Kapazität C des Überganges und der Induktivität L stabil werden und noch stärker zurückgehen. Es soll auch mit erwähnt werden, dass die Stabilität der Werte auch bei einer Temperaturschwankung (sowohl bei einer Senkung auf niedrige Werte, wie auch bei einem Anstieg auf hohe Werte) erhalten bleibt. Messungen wurden in einem Bereich von 173 K bis 393 K vorgenommen.

Abschliessend sei angemerkt, dass die vorstehend angeführten Beispiele nur für ein besseres Verständnis des Erfindungskernes und der -vorteile gedacht sind und sich in keinem Fall auf sämtliche mögliche, besondere Ausführungsformen erstrecken. Mit Blick auf das oben Dargestellte wird sich ein Fachmann auf dem Gebiet der Halbleitertechnik klar vorstellen, dass sich auch weitere konkrete Ausführungsformen der Erfindung anbieten, die insbesondere durch Substratstoffe, Strombahnen, Trennschichten od. dgl. gekennzeichnet sind, welche sich von denen, die in der Beschreibung direkt dargelegt sind, abweichen, gut bekannt sind und in diesem Bereich der Technik für ähnliche Zwecke Anwendung finden sowie durch eine Zahl von pn-Übergängen gekennzeichnet sind, die in der Beschreibung unmittelbar nicht zum Ausdruck kommt und die sich doch aus dem Erfindungswesen eindeutig ableitet, welcher zufolge diese Zahl mindestens 2 sein soll. Im Rahmen der vorliegenden Erfindung können Methoden für die Herstellung sowohl eines ganzen Wandlers, als auch dessen Einzelteile eingesetzt werden, die sich von den erwähnten bekannten Methoden unterscheiden. Möglich sind aber auch andere konkrete Ausführungsformen der Erfindung, die jedoch nicht über den Rahmen des beanspruchten Rechtsschutzes, der durch die beiliegenden Patentansprüche voll definiert ist, hinausgehen.

### Gewerbliche Anwendbarkeit

Die Erfindung ist für die Gewinnung der elektrischen Energie aus alternativen Quellen ( Quellen der elektromagnetischen Strahlung des sichtbaren Bereiches , der UV-, IR-Strahlung od. dgl.) geeignet. Dabei lässt sich die Erfindung bei Anwendung von genormten Halbleitertechnologien realisieren, die in dieser Etappe der Entwicklung der Technik gut bekannt sind, ohne dass irgendwelche, grundsätzlich neue zusätzliche Anlage eingesetzt sein soll.

## Patentansprüche

1. Wandler, enthaltend mindestens ein p-Gebiet und mindesten ein n-Gebiet sowie eine erste und eine zweite Elektrode, **dadurch gekennzeichnet, dass** der Wandler eine Zahl N > 1 der Gebiete mit gleichnamiger Leitfähigkeit, wobei N für eine ganze Zahl steht, und ein Gebiet mit entgegengesetzter Leitfähigkeit unter Bildung von N einzelner gleichartiger pn-Übergänge aufweist, wobei die erste Elektrode an jedes der genannten N Gebiete mit gleichnamiger Leitfähigkeit und die zweite Elektrode an das erwähnte Gebiet mit entgegengesetzter Leitfähigkeit angrenzt.

2. Wandler nach Anspruch 1, **dadurch gekennzeichnet, dass** die genannte erste Elektrode jedes der Gebiete mit gleichnamiger Leitfähigkeit über dessen Umfang umgreift.

3. Wandler nach Anspruch 1, **dadurch gekennzeichnet, dass** die genannte erste Elektrode jedes der angegebenen Gebiete mindesten teilweise abdeckt.

4. Wandler nach Anspruch 3, **dadurch gekennzeichnet, dass** die genannte erste Elektrode jedes der angegebenen Gebiete mit gleichnamiger Leitfähigkeit voll abdeckt.

5. Wandler nach Anspruch 4, **dadurch gekennzeichnet, dass** die an jedes der Gebiete mit gleichnamiger Leitfähigkeit angrenzenden Abschnitte der ersten Elektrode eine polygonale Form aufweisen.

6. Wandler nach Anspruch 5, **dadurch gekennzeichnet, dass** die an jedes der Gebiete mit gleichnamiger Leitfähigkeit angrenzenden Abschnitte der ersten Elektrode rechteckig ausgestaltet sind.

7. Wandler nach Anspruch 5, **dadurch gekennzeichnert, dass** die an jedes der Gebiete mit gleichnamiger Leitfähigkeit angrenzenden Abschnitte der ersten Elektrode hexagonal ausgestaltet sind.

8. Wandler nach Anspruch 5, **dadurch gekennzeichnert, dass** die an jedes der Gebiete mit gleichnamiger Leitfähigkeit angrenzenden Abschnitte der ersten Elektrode oktagonal ausgestaltet sind.

9. Wandler nach Anspruch 5, **dadurch gekennzeichnert, dass** die an jedes der Gebiete mit gleichnamiger Leitfähigkeit angrenzenden Abschnitte der ersten Elektrode zwölfeckig ausgestaltet sind.

10. Wandler nach einem der Ansprüche 3 bis 9, **dadurch gekennzeichnet, dass** zumindest ein Abschnitt der ersten Elektrode, der an eines der Gebiete mit gleichnamiger Leitfähigkeit angrenzt, in der Abdeckzone M > 1 parallel geschaltete und zu einer Strombaueinheit zudammengefasste gleichartige Einzelelemente umfasst, wobei M für eine ganze Zahl steht.

11. Wandler nach Anspruch 10, **dadurch gekennzeichnet, dass** zumindest eines der genannten gleichartigen Elemente des Abschnittes der ersten Elektrode von einem damit benachbarten ähnlichen Element durch einen Oxidspalt getrennt ist.

12. Wandler nach Anspruch 10, **dadurch gekennzeichnet, dass** zumindest eines der genannten gleichartigen Elemente des Abschnittes der ersten Elektrode von einem damit benachbarten ähnlichen Element durch eine durchgehende Öffnung in der ersten Elektrode getrennt ist.

13. Wandler nach Anspruch 12, **dadurch gekennzeichnet, dass** zumindest einer der an die Gebiete mit gleichnamiger Leitfähigkeit angrenzenden Abschnitte der ersten Elektrode K durchgehende Öffnungen aufweist, wobei K für eine ganze Zahl steht und K > 1 ist.

14. Wandler nach einem der Ansprüche 1 bis 9, 11 bis 13, **dadurch gekennzeichnet, dass** die gennanten Gebiete mit gleichnamiger Leitfähigkeit p-Gebiete sind und das Gebiet mit entgegengesetzter Leitfähigkeit ein n-Gebiet ist.

15. Wandler nach Anspruch 10, **dadurch gekennzeichnet, dass** die genannten Gebiete mit gleichnamiger Leitfähigkeit p-Gebiete sind und das Gebiet mit entgegegesetzter Leitfähigkeit ein n-Gebiet ist.

16. Wandler nach einem der Ansprüche 1 bis 9, 11 bis 13, **dadurch gekennzeichnet, dass** die genannten Gebiete mit gleichnamiger Leitfähigkeit n-Gebiete sind und das Gebiet mit entgegengesetzter Leitfähigkeit ein p-Gebiet ist.

17. Wandler nach Anspruch 10, **dadurch gekennzeichnet, dass** die genannten Gebiete mit gleichnamiger Leitfähigkeit n-Gebiete sind und das Gebiet mit entgegengesetzter Leitfähigkeit ein p-Gebiet ist.
